# EUROPEAN PATENT SPECIFICATION

(11) **EP 3 750 188 B1**
(45) Date of publication and mention of the grant of the patent: **14.06.2023**
(21) Application number: 19702625.5
(22) Date of filing: 06.02.2019
(51) Int. Cl.: H01L 27/15, H01L 33/06, H01L 33/24, H01L 33/00, H01L 33/04, H01L 33/18, H01L 33/20, H01L 33/32, H01L 33/44, H01L 33/50

(54) **RADIATION EMITTER, EMITTING DEVICE WITH THE SAME, CORRESPONDING FABRICATION METHODS, AND ASSOCIATED DISPLAY SCREEN**
STRAHLUNGSEMITTER, EMITTIERENDE VORRICHTUNG DAMIT, VERFAHREN ZUR HERSTELLUNG DAVON UND ZUGEHÖRIGER ANZEIGEBILDSCHIRM
ÉMETTEUR DE RAYONNEMENT, DISPOSITIF D'ÉMISSION L'INCORPORANT, PROCÉDÉS DE FABRICATION DE CEUX-CI, ET ÉCRAN D'AFFICHAGE ASSOCIÉ

(30) Priority: 07.02.2018 FR 1851027
(43) Date of publication of application: 16.12.2020
(73) Proprietor: Aledia, 38130 Echirolles (FR)
(72) Inventor: TAN, Wei Sin, 38240 MEYLAN (FR); RUEDA FONSECA, Pamela, 38600 FONTAINE (FR); GILET, Philippe, 38470 TECHE (FR)
(74) Representative: Lavoix
(86) International application number: PCT/EP2019/052942
(87) International publication number: WO 2019/154878

(56) References cited:
- US-A- 5 952 681
- US-A1- 2003 157 741
- US-A1- 2004 129 929
- US-A1- 2008 277 682
- US-A1- 2011 012 169
- US-A1- 2011 114 917
- US-A1- 2013 228 791
- US-A1- 2017 110 630
- G.F. YANG ET AL: "InGaN/GaN multiple quantum wells on selectively grown GaN microfacets and the applications for phosphor-free white light-emitting diodes", REVIEWS IN PHYSICS, vol. 1, 1 November 2016 (2016-11-01), pages 101-119, XP055537837, ISSN: 2405-4283, DOI: 10.1016/j.revip.2016.06.001

## Description

The present invention concerns an emitter. The present invention also concerns an emitting device comprising at least two such emitters. The present invention also concerns a display screen comprising a set of such emitting devices. The present invention likewise concerns a method for fabricating such an emitter.

Light-emitting structures comprise a stack of superimposed semiconducting layers structured so as to form a set of separate light-emitting mesas. Such structures are usually fabricated by etching away part of a stack of two-dimensional layers so as to define the light-emitting mesas. The light emission is provided by a light-emitting layer that is usually situated at or near the top of the mesas.

Since the light-emitting mesas are separated from each other, such structures allow for an easy control of the emission of each mesa, as each mesa may be independently supplied with electricity with a reduced risk of current leakage to a neighboring mesa. Because of the aforementioned advantages, it has been suggested to use such light-emitting structures as part of display screens, with each mesa forming a pixel if the screen is a monochrome screen, or a sub-pixel if the screen is a polychrome screen. The spatial resolution of such a display screen is therefore directly linked to the lateral dimensions of the mesa.

However, the exposed lateral sides of the mesas give rise to increased surface recombination of carriers. The overall light emission efficiency (also called "wall-plug efficiency") of such structures therefore decreases with the lateral dimensions of the mesas, since reduced lateral dimensions lead to a relative increase of the surface of the lateral sides compared to the surface of the light-emitting layer. In consequence, the wall-plug efficiency of mesa-based pixels or display screens decreases when the screen resolution increases, in particular when the lateral dimension of the mesas is of the order of 10 micrometers (µm) or less.

US 2011/0012169 A1 discloses various mesa-shaped, III-nitride semiconductor light-emitting devices grown on a patterned mask on a silicon substrate. These devices are useful as light sources for white illumination, for liquid crystal backlights, and also for outdoor displays.

US 2003/0157741 A1 discloses various micro-sized, hexagonal pyramid- or truncated hexagonal pyramid-shaped, GaN-based light-emitting devices grown on a mask on a substrate. These devices are integrated as an array into a display unit.

There is therefore a need for a light emitter having small lateral dimensions and having a high wall-plug efficiency.

For this, the present invention concerns an emitter in accordance with the appended claim 1, adapted to emit a first radiation, the emitter comprising:
- a substrate,
- a mesa, the mesa being made of a first semiconductor material, the first semiconductor material having a first bandgap value, the mesa having a superior side and a lateral side, the lateral side surrounding the superior side and extending between the substrate and the superior side,
- a covering layer comprising at least one radiation-emitting layer, the at least one radiation-emitting layer being made of a second semiconductor material, the second semiconductor material having a second bandgap value, the second bandgap value being strictly inferior to the first bandgap value, each radiation-emitting layer having a first portion corresponding to the superior side and a second portion corresponding to the lateral side, a first thickness being defined for the first portion and a second thickness being defined for the second portion, the second thickness being strictly inferior to the first thickness, the ratio between the first thickness and the second thickness being comprised between 1.5 and 6, and the superior side having a surface comprised between 9 square micrometers and 900 square micrometers.

According to specific embodiments, the emitter comprises one or several of the following features, taken separately or according to any possible combination:
- at least one of the following properties is fulfilled:
   - the first portion covers at least partially the superior side of the mesa and the second portion covers at least partially the lateral side of the mesa;
   - the second portion forms at least one quantum well, and
   - the lateral side comprises a plurality of plane faces.
- at least one of the following properties is fulfilled:
   - the substrate is made of a semiconducting material, the mesa extending along a first direction perpendicular to the substrate from the substrate and being electrically connected to the substrate, the substrate having a main surface surrounding the mesa in a plane perpendicular to the first direction, the substrate further comprising an electrically insulating layer extending on the main surface, the insulating layer forming a barrier between the substrate and the covering layer, and
   - for each point of the lateral side, an axis corresponding to the direction passing through the point and perpendicular to the lateral side is defined, and wherein the angle between a first direction perpendicular to the substrate and the axis is comprised between 30 degrees and 80 degrees.
- at least one of the following properties is fulfilled:
   - at least one of the first semiconductor material and the second semiconductor material is a III-nitride material, and
   - a crystalline structure is defined for the first semiconductor material, the crystalline structure having at least one polar direction and at least one semipolar direction, the superior side being perpendicular to the polar axis, an axis corresponding to the direction passing through the lateral side and perpendicular to the lateral side being defined for each point of the lateral side, the axis being perpendicular to the semipolar direction.

- at least one of the following properties is fulfilled:
   - the emitter further comprises a first electrical contact electrically connected to the first portion, the emitter being configured to emit the first radiation when an electrical current flows through the first electrical contact, the covering layer and the mesa, the first electrical contact further being electrically connected to the second portion ;
   - the emitter further comprises a first electrical contact electrically connected to the first portion, the emitter being configured to emit the first radiation when an electrical current flows through the first electrical contact, the covering layer and the mesa, the first electrical contact comprising a first connection layer and a second barrier layer, the second barrier layer being interposed between the first connection layer and the covering layer, the first connection layer being made of a fourth material, the fourth material being a electrically conductive material or a semiconducting material, the second barrier layer being made of an insulating material, the covering layer, the second barrier layer and the first connection layer forming a tunnel junction;
   - the covering layer comprises at least two superimposed radiation-emitting layers made of the second semiconductor material, a first barrier layer made of a third semiconductor material being interposed between each pair of successive radiation-emitting layers, the third semiconductor material having a third bandgap value, the third bandgap value being strictly superior to the second bandgap value, and
   - the first radiation comprises a first set of electromagnetic waves, the radiation-emitting layer being configured to emit a second radiation comprising a second set of electromagnetic waves, the emitter further comprising a radiation converter configured to absorb the second radiation and to emit in response the first radiation, a wavelength being defined for each electromagnetic wave, the first set corresponding to a first range of wavelengths and the second set corresponding to a second range of wavelengths, the first range having a first mean wavelength and the second range having a second mean wavelength, the first mean wavelength being different from the second mean wavelength.
- at least one of the following properties is fulfilled:
   - the mesa has a minimum lateral dimension and a height, the height being measured in a first direction perpendicular to the substrate and the minimum lateral dimension being measured in a plane perpendicular to the first direction, the height being strictly inferior to the minimum lateral dimension;
   - the mesa forms a frustum having a base in contact with the substrate, the base being a rectangle;
   - the mesa forms a frustum having a base in contact with the substrate, the base being a hexagon;
   - the mesa has a height measured along a first direction perpendicular to the substrate, the height being comprised between 100 nanometers and 1000 nanometers.

An emitting device comprising at least two emitters as previously defined is also proposed.

According to specific embodiments, the emitting device comprises one or several of the following features, taken separately or according to any possible combination:
- the lateral sides of the mesas are in contact with each other.
- each emitter comprises a first electrical contact electrically connected to the first portion of the emitter, the emitting device further comprising a single connecting structure, the connecting structure comprising a mesa, a covering layer and a second electrical contact, the second electrical contact covering at least partially the superior side and at least partially the lateral side of the mesa of the connecting structure, the second electrical contact being electrically connected to the substrate, each emitter being configured to emit the corresponding first radiation when an electrical current flows through the corresponding first electrical contact, the corresponding covering layer, the corresponding mesa, the substrate and the second electrical contact.
- the emitting device comprises three emitters, each first radiation comprising a first set of electromagnetic waves, a wavelength being defined for each electromagnetic wave, each first set corresponding to a first range of wavelengths, each first range having a corresponding first mean wavelength, the first mean wavelength of each emitter being different from the first mean wavelength of each other emitter.

A display screen comprising a set of emitting devices as previously defined is also proposed.

The present invention also concerns a method in accordance with the appended claim 10, for fabricating an emitter adapted to emit a first radiation, the method comprising steps for:
- supplying a substrate,
- creating a mesa made of a first semiconductor material, the first semiconductor material having a first bandgap value, the mesa having a superior side and a lateral side, the lateral side surrounding the superior side and extending between the substrate (55) and the superior side, and
- depositing on the mesa a covering layer comprising at least one radiation-emitting layer, the at least one radiation-emitting layer being made of a second semiconductor material, the second semiconductor material having a second bandgap value, the second bandgap value being strictly inferior to the first bandgap value, each radiation-emitting layer having a first portion corresponding to the superior side and a second portion corresponding to the lateral side, a first thickness being defined for the first portion and a second thickness being defined for the second portion, the second thickness being strictly inferior to the first thickness, the ratio between the first thickness and the second thickness being comprised between 1.5 and 6, and the superior side having a surface comprised between 9 square micrometers and 900 square micrometers.

The present invention further concerns a method in accordance with the appended claim 12, for fabricating an emitting device comprising a first emitter and at least one second emitter, each emitter being adapted to emit a corresponding first radiation, the method comprising steps for:
- supplying a substrate,
- creating, for each emitter, a mesa made of a first semiconductor material, the first semiconductor material having a first bandgap value, the mesa having a superior side and a lateral side, the lateral side surrounding the superior side and extending between the substrate and the superior side, and
- depositing on each mesa a covering layer comprising at least one radiation-emitting layer, the at least one radiation-emitting layer being made of a second semiconductor material, the second semiconductor material having a second bandgap value, the second bandgap value being strictly inferior to the first bandgap value, each radiation-emitting layer having a first portion corresponding to the superior side and a second portion corresponding to the lateral side, a first thickness being defined for the first portion and a second thickness being defined for the second portion, the second thickness being strictly inferior to the first thickness, the ratio between the first thickness and the second thickness being comprised between 1.5 and 6, and the superior side having a surface comprised between 9 square micrometers and 900 square micrometers.

According to a specific embodiment, the substrate has a first side and a second side, the first side supporting the mesas, the first side and the second side being parallel to each other, each first radiation comprising a first set of electromagnetic waves, the radiation-emitting layer of each second emitter being configured to emit a second radiation comprising a second set of electromagnetic waves, the method further comprising a step for forming, for each emitter, a first electrical contact electrically connected to the first portion, the emitter being configured to emit the corresponding first radiation when an electrical current flows through the first electrical contact, the covering layer and the mesa. The method also comprises a step for connecting each first electrical contact to a control circuit adapted to generate each electrical current and a step for placing, on the second side of the substrate, a radiation converter configured to absorb the second radiation and to emit in response the first radiation corresponding to the second emitter, a wavelength being defined for each electromagnetic wave, the first set of the second emitter corresponding to a first range of wavelengths and the second set corresponding to a second range of wavelengths, the first range having a first mean wavelength and the second range having a second mean wavelength, the first mean wavelength being different from the second mean wavelength.

Features and advantages of the invention, as defined by the appended claims, will be made clear by the following
specification, given only as a non-limiting example, and making a reference to the annexed drawings, on which:
- Figure 1 is a partial top view of a display screen comprising a set of emitting devices,
- Figure 2 is a side view of a section of an emitting device along line II-II on figure 1, each emitting device comprising a set of emitters,
- Figure 3 is an enlarged side view of a section of an emitter of figure 2,
- Figures 4 to 12 are schematic views of the results at various stages of an example of a method for fabricating an emitting device,
- Figures 13 to 17 are schematic side views of examples of emitting devices,
- Figures 18 to 20 are schematic views of the results at various stages of another example of a method for fabricating an emitting device, and
- Figure 21 is a schematic side view of another example of emitting device.

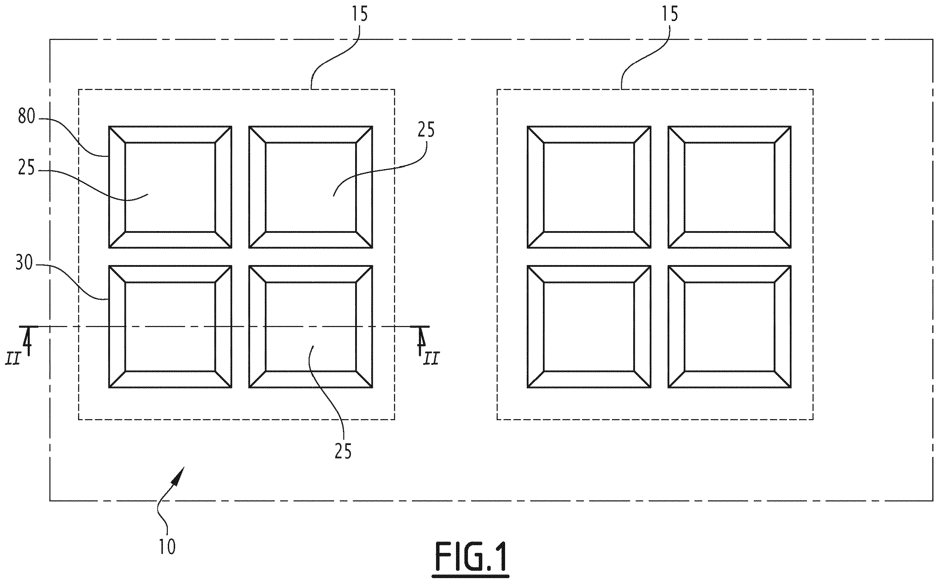

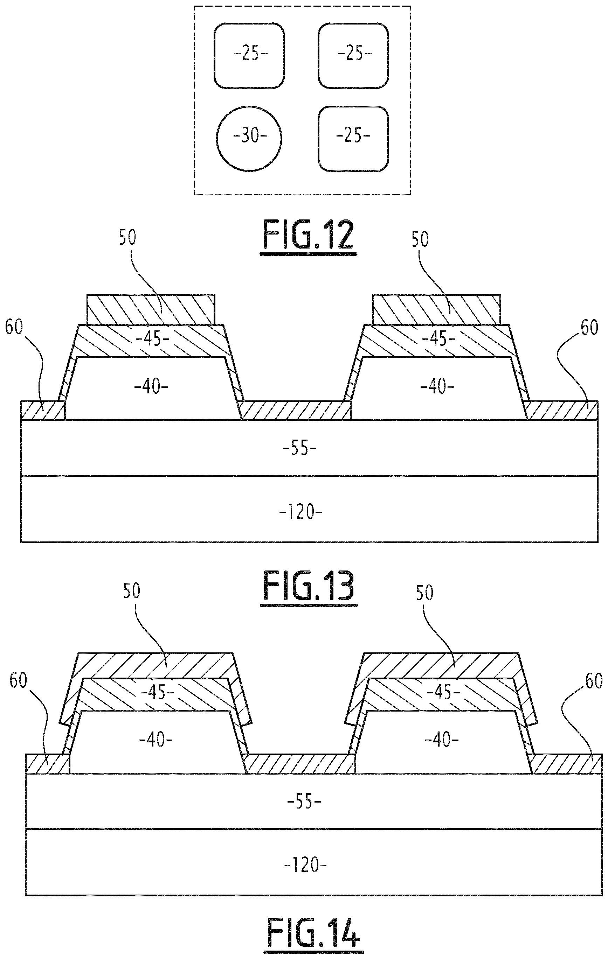

A display screen 10 is partially shown on figure 1 and schematically represented in figure 12.

The display screen 10 is, for example, integrated in an electronic device such as a mobile phone, a tablet or a laptop computer. In another embodiment, the display screen 10 may be integrated in dedicated display device such as a television set, a desktop computer screen, smart watch or smart glasses.

The display screen 10 is configured for displaying a set of images.

The display screen 10 comprises a set of emitting devices 15 and a control circuit 20.

Each emitting device 15, also called "picture element", or in short "pixel" is configured for emitting at least one first radiation.

For convenience, in what follows, the emitting device 15 is named pixel 15.

For example, each pixel 15 is configured to emit one of a set of electromagnetic waves comprising three first radiations.

In variant, embodiments with a pixel 15 configured for emitting more or less than three radiations (for instance four) can be considered.

Each first radiation comprises a first set of electromagnetic waves.

A wavelength is defined for each electromagnetic wave.

Each first set corresponds to a first range of wavelengths. The first range of wavelengths is the group formed by all the wavelengths of the first set of electromagnetic waves.

A first mean wavelength is defined for each first range of wavelengths.

Each pixel 15 comprises at least one light emitter 25, and at least one connecting structure 30. For example, each pixel 15 comprises three light emitters 25 and a single connecting structure 30.

Each light emitter 25 is configured to emit a respective first radiation. In particular, each light emitter 25 is configured to emit the respective first radiation when a first electrical current flows through the light emitter 25.

The first mean wavelength of each light emitter 25 is, for example, different from the first mean wavelength of each other light emitter 25 of the same pixel 15.

According to one embodiment, the first mean wavelength of one light emitter 25 is comprised between 430 nanometers (nm) and 480 nm, the first mean wavelength of another light emitter 25 is comprised between 500 nm and 560 nm and the first mean wavelength of the third light emitter 25 is comprised between 580 nm and 680 nm.

Embodiments in which the first mean wavelengths of two different light emitters 25 of a single pixel 15 are identical may also be considered.

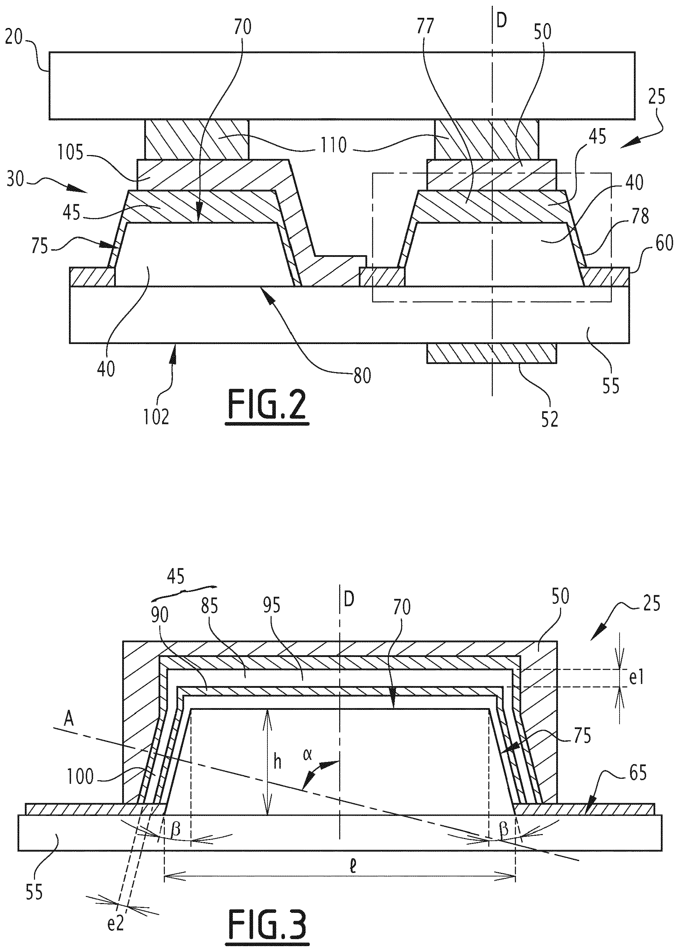

As shown on figure 2, each light emitter 25 comprises a substrate 55, a mesa 40, a covering layer 45, a first electrical contact 50, a radiation converter 52 and an insulating layer 60.

The substrate 55 is configured to support the mesa 40, the covering layer 45 and the first electrical contact 50.

The substrate 55 is, for example, common to all light emitters 25 and to the contact block or connecting structure.

In some embodiments, the substrate 55 may further comprise a support plate 120. In the embodiment shown on figures 2 and 3, the substrate 55 does not comprise any support plate 120.

The substrate 55 is, for example, planar. A planar substrate is a substrate having a planar main surface 65.

A normal direction D is defined for the substrate 55. The main surface 65 of the substrate 55 is perpendicular to the normal direction D.

The main surface 65 surrounds each mesa 40 in a plane perpendicular to the normal direction D.

The substrate 55 is made of a first semiconductor material. A first bandgap value is defined for the first semiconductor material.

The expression "bandgap value" shall be understood as meaning the value of the forbidden band between the valence band and the conduction band of the material.

The bandgap value is, for example, measured in electron-volts (eV).

The valence band is defined as being, among the energy bands which are allowed for electrons in the material, the band that has the highest energy while being completely filled at a temperature inferior or equal to 20 Kelvin (K).

A first energy level is defined for each valence band. The first energy level is the highest energy level of the valence band.

The conduction band is defined as being, among the energy bands which are allowed for electrons in the material, the band that has the lowest energy while not being completely filled at a temperature inferior or equal to 20 K.

A second energy level is defined for each conduction band. The second energy level is the highest energy level of the conduction band.

Thus, each bandgap value is measured between the first energy level and the second energy level of the material.

A semiconductor material is a material having a bandgap value strictly superior to zero and inferior or equal to 6.5 eV.

The first semiconductor material is, for example, a III-nitride material. III-nitride materials are a group of materials comprising GaN, AIN and InN and the alloys of GaN, AIN and InN.

According to an embodiment, the first material is GaN.

Doping is defined as the presence, in a material, of impurities bringing free charge carriers. Impurities are, for example, atoms of an element that is not naturally present in the material.

When the impurities increase the volumic density of holes in the material, with respect to the undoped material, the doping is p-type. For example, a layer of GaN is p-doped by adding magnesium (Mg) atoms.

When the impurities increase the volumic density of free electrons in the material, with respect to the undoped material, the doping is n-type. For example, a layer of GaN is n-doped by adding silicon (Si) atoms.

The first material is, for example, n-doped. However, the type of doping may vary in some embodiments.

The first material is, for example, a crystalline material. A crystal or crystalline material is a solid material whose constituents (such as atoms, molecules, or ions) are arranged in a highly ordered microscopic structure, forming a crystal lattice that extends in all directions.

A crystalline structure is defined for the first material. In crystallography, crystal structure is a description of the ordered arrangement of atoms, ions or molecules in a crystalline material.

The crystalline structure is, for example, a polar structure. A polar structure is a crystalline structure wherein the barycenters of the positive and negative electric charges are spatially separate.

The crystalline structure has, for example, a polar direction, at least one nonpolar direction and at least one semipolar direction.

A polar direction is a direction along which the barycenters of the positive and negative electric charges are spatially separate.

A non-polar direction is a direction along which the barycenters of the positive and negative electric charges are identical.

A semipolar direction is a direction that forms a non-zero angle with both the polar axis and every non-polar directions of the material.

For example, the crystalline structure is a hexagonal structure such as wurtzite. Wurtzite is the most common crystalline structure of III-nitrides. The polar axis of wurtzite structure is called c-axis.

The normal direction D is, for example, parallel to the polar direction of the crystalline structure.

The insulating layer 60 extends on the main surface 65. The insulating layer 60 surrounds, for example, each mesa 40 in a plane perpendicular to the normal direction D.

The insulating layer 60 is made of an electrically insulating material. For example, the insulating layer 60 is made of silicon oxide.

The insulating layer 60 forms a barrier between the covering layer 45 and the substrate 55. In particular, the insulating layer 60 prevents an electrical current from flowing between the covering layer 45 and the substrate 55 without flowing through the mesa 40.

Each mesa 40 extends from the substrate 55 along the normal direction D.

Each mesa 40 has a superior side 70, a lateral side 75 and a base 80.

The mesa 40 is delimited along the normal direction D by the base 80 and the superior side 70.

Each mesa 40 is, for example, in the shape of a frustum.

In geometry, a frustum is the portion of a solid that lies between one or two parallel planes cutting the solid. A truncated pyramid is an example of a frustum.

For example, the mesa 40 is in the shape of a truncated right pyramid. In geometry, a pyramid is a polyhedron formed by connecting a polygonal base 80 and a point, called the apex. A right pyramid has its apex directly above the centroid of its base 80.

More precisely, the mesa 40 is in the shape of a truncated pyramid whose apex is aligned with the centroid of the base 80 along the normal direction D.

Each mesa 40 has a height h measured along the normal direction D and lateral dimensions measured in a plane perpendicular to the normal direction. Among the lateral dimensions, a minimum lateral dimension I of the mesa is defined as the dimension of the mesa 40, measured along the direction along which, among all directions perpendicular to the normal direction D, the mesa 40 has the smallest dimension.

When the mesa 40 is in the shape of a truncated right pyramid whose base 80 has an even number of sides, the minimum lateral dimension I is the distance between two opposite sides of the base 80.

The height h is strictly inferior to the minimum lateral dimension I.

The height h is comprised between 100 nm and 2 µm, for example comprised between 100 nm and 1 µm.

The mesa 40 is made of a semiconductor material. For example, the mesa 40 is made of the first semiconductor material.

The mesa 40 is electrically connected to the substrate 55. In an embodiment, the mesa 40 is integral with the substrate 55.

The superior side 70 is, for example, planar. In the embodiment shown on figure 2, the superior side 70 is perpendicular to the normal direction D.

The superior side 70 is polygonal.

As shown on figure 1, the base 80 is, for example, rectangular. A square superior side 70 is an example of rectangular superior side 70.

In other embodiments, the superior side 70 is hexagonal or triangular.

The superior side 70 has a surface comprised between 9 square micrometers (µm²) and 900 square micrometers (µm²).

The lateral side 75 extends between the substrate 55 and the superior side 70.

As visible in figure 3, the lateral side 75 surrounds the superior side 70. The lateral side 75 delimits the mesa 40 in a plane perpendicular to the normal direction D.

An axis A is defined for each point of the lateral side 75. The axis A corresponds to the direction passing through the point and perpendicular in that point to the lateral side 75.

An angle α between the normal direction and the axis A is, in any point of the lateral side 75, strictly inferior to 90 degrees (°). In particular, the angle α is comprised between 30 and 80°. For example, each axis A is perpendicular to a semipolar direction.

In other words, an angle β between the normal direction D and a line on the lateral side 75, the line being comprised in a vertical plane comprising the normal direction D, is strictly superior to zero, for example comprised between 10° and 60°.

According to an embodiment, each angle α is comprised between 50° and 80°. In other words, the angle β is comprised between 10 ° and 40°.

According to an embodiment, the angle α is comprised between 55° and 65°.

The lateral side 75 comprises, for example, a plurality of plane faces. In particular, when the mesa 40 is a truncated pyramid, each plane face is rectangular and extends from one side of the base 80 to one side of the superior side 70. In this case, the angles α of any two points of a same plane face are identical.

According to an embodiment, the lateral sides 75 of at least two emitters 25 of a single pixel are in contact with each other.

The base 80 of the mesa 40 is in contact with the substrate 55.

The base 80 has a surface strictly superior to the surface of the superior side 70.

The base 80 is polygonal. A rectangular or hexagonal base 80 are examples of polygonal bases 80. For example, the shape of the base 80 is the same as the shape of the superior side 70.

According to the example shown on figure 1, the sides of the bases 80 of each mesa 40 are parallel to each other.

The covering layer 45 is shown in greater detail on figure 3.

The covering layer 45 covers at least part of the mesa 40.

The covering layer 45 is adapted to transmit the first electrical current from the mesa 40 to the first electrical contact 50.

The covering layer 45 extends on at least part of the superior side 70 and at least part of the lateral side 75. In particular, the covering layer 45 has a top portion 77 in contact with the superior side 70 and a lateral portion 78 in contact with the lateral side 75.

Each covering layer 45 is interposed between the first electrical contact 50 and the mesa 40 so that the first electrical current flowing between the mesa 40 and the first electrical contact 50 flows through the covering layer 45.

The covering layer 45 comprises at least one radiation-emitting layer 85. For example, the covering layer 45 comprises a plurality of superimposed radiation-emitting layers 85 and at least one first barrier layer 90.

The covering layer 45 is configured so that, when the first electrical current flows through the covering layer 45, the first electrical current flows through each radiation-emitting layer 85.

Each radiation-emitting layer 85 is configured to emit a radiation when the first electrical current flows through the radiation-emitting layer 85. For example, each radiation-emitting layer 85 is configured to emit a second radiation.

Each second radiation comprises a second set of electromagnetic waves.

Each second set of electromagnetic waves corresponds to a second range of wavelengths. The second range of wavelengths is the group formed by all the wavelengths of the second set of electromagnetic waves.

A second mean wavelength is defined for each second range of wavelengths. The second mean wavelength is different from the first mean wavelength of the first radiation corresponding to the light emitter 25 of which the radiation-emitting layer 85 constitutes a part. For example the second mean wavelength is strictly inferior to the first mean wavelength.

According to another embodiment, the second mean wavelength is equal to the first mean wavelength of the first radiation

The first semiconductor material is transparent to the second radiation.

Each radiation-emitting layer 85 is made of a second semiconductor material.

The second semiconductor material has a second bandgap value. The second bandgap value is strictly inferior to the first bandgap value.

The second semiconductor material is a crystalline material. For example, the second semiconductor material has the same crystalline structure as the first semiconductor material. Embodiments wherein the second semiconductor material has a different crystalline structure from the first semiconductor material may be envisioned.

The second semiconductor material is, for example, a III-N material. In particular, when the first semiconductor material is GaN, the second semiconductor material is InGaN.

Each radiation-emitting layer 85 extends on the lateral side 75 and on the superior side 70.

In particular, each radiation-emitting layer 85 covers at least part of the lateral side 75 and on the superior side 70. In other words, each radiation-emitting layer 85 is supported by the lateral side 75 and the superior side 70.

Each radiation-emitting layer 85 has a first portion 95 and a second portion 100.

The first portion 95 of a radiation-emitting layer 85 is the portion of the radiation-emitting layer 85 that is part of the top portion 77 of the covering layer 45.

The first portion 95 corresponds to the superior side 70. In particular, the first portion 95 covers at least part of the superior side 70. For example, the first portion 95 covers entirely the superior side 70.

The first portion 95 is perpendicular to the normal direction D.

The first portion 95 has a first thickness e1. The first thickness e1 is measured along the normal direction D.

In the case of a single quantum well, the first thickness e1 is comprised between 1 nm and 20 nm.

The first portions 95 of all radiation-emitting layers 85 in a same emitter 25 are superimposed along the normal direction D. In other words, the first portions 95 form a stack of first portions 95 stacked along the normal direction D.

The second portion 100 of a radiation-emitting layer 85 is the portion of the radiation-emitting layer 85 that is part of the lateral portion 78 of the covering layer 45.

The second portion 100 corresponds to the lateral side 75. In particular, the second portion 100 covers at least part of the lateral side 75.

According to an embodiment, the second portion covers at least 30 percent (%) of the surface of the lateral side 75. For example, the second portion 100 covers at least 50 % of the lateral side 75. Embodiments where the second portion 100 covers at least 90 % of the lateral side 75, notably covers entirely the lateral side 75, may be envisioned.

The above values of the percentage of the surface of the lateral side 75 covered by the second portion are, for example, calculated by considering only the surface of the lateral side 75 that is not in contact with the insulating layer 60.

However, embodiments where the percentage of the surface of the lateral side 75 covered by the second portion is calculated by considering both the surface of the lateral side 75 that is not in contact with the insulating layer 60 and the surface of the lateral side 75 that is covered by the insulating layer 60 may be considered.

The second portion 100 is perpendicular, in any point of the lateral side 75, to the axis A.

The second portions 100 of all radiation-emitting layers 85 in a same emitter 25 are superimposed with each other. In other words, these second portions 100 form a stack of second portions 100. The second portions 100 are stacked along the axis A.

Each second portion 100 has a second thickness e2. The second thickness e2 is measured, in any point of the second portion 100, along the corresponding axis A.

The second thickness e2 is strictly inferior to the first thickness e1 and the ratio of the first thickness e1 and the second thickness e2 is comprised between 1.5 and 6.

The second portion 100 is arranged so that an energy level of charge carriers inside the second portion 100 is strictly superior to an energy level of charge carriers inside the first portion 95.

The second thickness e2 is such that the second portion 100 forms a quantum well for the charge carriers in the second material.

Structurally, a single quantum well is made by interposing a layer of a first semiconductor material between two layers of a second semiconductor material, the doped first semiconductor material and the second semiconductor material have different bandgap values. By contrast, a multiple quantum well structure is a stack of semiconductor layers with an alternation of quantum wells and barriers.

Functionally, a quantum well is a structure in which quantum confinement occurs, for at least one type of charge carriers, in one direction. The effects of quantum confinement take place when the dimension of the structure along that direction becomes comparable to or smaller than the de Broglie wavelength of the carriers, which are generally electrons and/or holes, leading to energy levels called "energy subbands".

In such a quantum well, carriers may have only discrete energy values but are, usually, able to move within a plane perpendicular to the direction in which the confinement occurs. The energy values available to the carriers, also called "energy levels", increase when the dimensions of the quantum well decrease along the direction in which the confinement occurs. Thus, since the second thickness e2 of the second portion 100 is smaller than the first thickness e1 of the first portion 95, the energy levels in the second portion 100 are higher than the energy levels in the first portion 95.

In quantum mechanics, the "de Broglie wavelength", is the wavelength of a particle when the particle is considered as a wave. The de Broglie wavelength of electrons is also called "electronic wavelength". The de Broglie wavelength of a charge carrier depends of the material in which the carrier is.

A second portion 100 having a second thickness e2 strictly inferior to the product of the electronic wavelength of the electrons in the second semiconducting material with five is an example of quantum well.

The second thickness e2 is, for example, comprised between 0.3 nm and 10 nm.

Each barrier layer 90 is made of a third semiconductor material. The third semiconductor material has a third bandgap value. The third bandgap value is strictly greater than the second bandgap value.

In an embodiment, the third semiconductor material is the first semiconductor material. For example, the third semiconductor material is a III-nitride material such as GaN.

The third semiconductor material is, for example, doped. The type of doping of the third semiconductor material is, for example, different from the type of doping of the first semiconductor material. In particular, the third semiconductor material is p-doped.

One barrier layer 90 is interposed between each pair of successive radiation-emitting layers 85.

In an embodiment, one barrier layer 90 also covers the radiation-emitting layer 85 which is the furthest from the mesa 40. This barrier layer 90 forms a barrier between the radiation-emitting layer 85 which is the furthest from the mesa 40 and the outside of the emitter 25.

Each barrier layer 90 has a thickness comprised between 1 nm and 30 nm. The first electrical contact 50 is configured to transmit the first electrical current from the control circuit 20 to the covering layer 45.

The first electrical contact 50 is in contact with the top portion 77 of the covering layer 45. For example, the first electrical contact 50 is electrically connected to both the top portion 77 and to the lateral portion 78, and therefore to both the first portion 95 and the second portion 100 of the light-emitting layer 85.

The first electrical contact 50 is, for example, made of a metallic material.

In another embodiment, the first electrical contact 50 comprises a connection layer and a second barrier layer.

The connection layer is made of a fourth material. The fourth material is an electrically conductive material or a semiconducting material. The fourth material is heavily doped of a first conductivity type with dopants at a dopant concentration greater than 10¹⁹ atoms/cm³, preferably greater than 10²⁰ atoms/cm³.

The second barrier layer is made of an electrically insulating material.

The second barrier layer is interposed between the connection layer and the covering layer 45.

The second barrier layer is configured so that the covering layer 45, the second barrier layer and the connection layer form a tunnel junction.

In such context, the covering layer is a semiconductor heavily doped of a second conductivity type with dopants at a dopant concentration greater than 10¹⁹ atoms/cm³, preferably greater than 10²⁰ atoms/cm³. The second conductivity type is different from the first semiconductor type.

A tunnel junction is a structure comprising a barrier, such as a thin insulating layer or electric potential, between two electrically conducting materials. Due to the thinness of the barrier, electrons may pass through the barrier by the technique of quantum tunneling even though the barrier is made of an insulating material.

The second barrier layer has a thickness comprised between 50 nm and 300 nm. The radiation converter 52 is adapted to convert the second radiation into the first radiation.

The radiation converter 52 is a photoluminescent material, for example, a phosphor or a nanophosphor.

In variant, the photoluminescent material is set of particles. An example of a photoluminescent material is yttrium aluminum garnet (YAG) activated by the trivalent cerium ion, also called YAG:Ce or YAG:Ce3+. The average size of the particles of conventional photoluminescent materials is greater than 5 µm.

In an embodiment, the photoluminescent material is a matrix having nanometer-range monocrystalline particles of a semiconductor material, also called semiconductor nanocrystals or nanophosphors particles hereafter, dispersed therein

According to an embodiment, the average size of the nanocrystals is in the range from 0.5 nm to 1,000 nm, preferably from 0.5 nm to 500 nm, more preferably from 1 nm to 100 nm, particularly from 2 nm to 30 nm. For dimensions smaller than 50 nm, the photoconversion properties of semiconductor nanocrystals essentially depend on quantum confinement phenomena. The semiconductor nanocrystals then correspond to quantum boxes or quantum dots.

According to an embodiment, the semiconductor material of the semiconductor crystals is selected from the group comprising cadmium selenide (CdSe), indium phosphide (InP), cadmium sulfide (CdS), zinc sulfide (ZnS), zinc selenide (ZnSe), cadmium telluride (CdTe), zinc telluride (ZnTe), cadmium oxide (CdO), zinc cadmium oxide (ZnCdO), cadmium zinc sulfide (CdZnS), cadmium zinc selenide (CdZnSe), silver indium sulfide (AgInS2), and a mixture of at least two of these compounds.

The matrix is made of an at least partly transparent material. The matrix is for example made of silica. The matrix is for example made of any at least partly transparent polymer, particularly of silicone, epoxy or of polyacetic acid (PLA). The matrix may be made of an at least partly transparent polymer used with three-dimensional printers, such as PLA. According to an embodiment, the matrix contains from 2% to 90%, preferably from 10% to 60%, by mass of nanocrystals, for example, approximately 20% by mass of nanocrystals.

According to other possible embodiments, the radiation converter 52 comprises a group of semiconducting particles embedded in a photosensitive resin. As shown on figure 2, the radiation converter 52 is supported by a bottom face 102 of the substrate 55 opposite the main surface 65, and facing the mesa 40.

The bottom face 102 is, for example, parallel to the main surface 65. In the example shown on figure 2, the bottom face 102 delimits the substrate 55 along the normal direction D.

The substrate 55 is, for example, delimited along the normal direction D by the main surface 65 and the bottom surface 102.

A distance between the bottom surface 102 and the main surface 65, measured along the normal direction is, for example, comprised between 500 nm and 50 µm.

The connecting structure 30 is configured to electrically connect the substrate 55 and the control circuit 20.

The connecting structure 30 comprises, for example, a mesa 40, a covering layer 45 and a second electrical contact 105.

The mesa 40 and the covering layer 45 of the connecting structure 30 are identical to the mesa 40 and the covering layer 45 of the light emitters.

The second electrical contact 105 connects electrically the control circuit 20 and the substrate 55. For example, the second electrical contact 105 connects the control circuit 20 and the substrate 55 through the insulating layer 60.

The second electrical contact 105 is made of an electrically conducting material such as a metallic material.

The second electrical contact 105 is supported by the mesa 40 and the covering layer 45 of the connecting structure 30. For example, the second electrical contact 105 covers at least part of the top portion 77 and the lateral portion 78 of the connecting structure 30.

The control circuit 20 is configured to generate the first electrical current corresponding to each light emitter 25 and to transmit each first electrical current to the corresponding light emitter 25.

The control circuit 20 comprises, for example, connection pads 110 connected each to a first or second electrical contact 50, 105.

More precisely, the connection pad 110 corresponding to the second electrical contact 105 is in contact with a part of the second electrical contact 105. Said part of the second electrical contact 105 is interposed between the first portion 95 of the corresponding covering layer 45 and the connection pad 110.

The operation of the light emitter 25 will now be described.

When the control circuit 20 generates the first electrical current, the first electrical current flows, sequentially, through the second electrical contact 105, the substrate 55, the mesa 40, the covering layer 45 and the first electrical contact 50.

The current flow results in the arrival of electrons and holes in each light-emitting layer 85. The recombination of electron-hole pairs in the light-emitting layer or layers 85 leads to the emission of the second radiation.

At least part of the second radiation is absorbed by the converter 52. The absorption of the second radiation causes the converter to emit the first radiation.

During the operation of the light emitter 25, the charge carriers are repulsed by the second portions 100 of the light-emitting layer or layers 85 because the energy levels of the charge carriers in the second portions 100 are higher than the energy levels of the same carriers inside the first portions 95. The charge carriers are therefore driven away from the lateral side 75 of the mesa 40.

The surface recombination of carriers on the lateral side 75 of the mesa 40 is therefore decreased when compared with a light emitter 25 that does not comprise second portions 100. In consequence, the emission efficiency of the light emitter 25 is higher than that of a light emitter 25 known in the state of the art.

Such an effect increases when the lateral dimension of the mesas 40 decreases. Furthermore, this effect is stronger if 30 % or more of the surface of the lateral side 75 is covered by the second portion 100.

Using a second portion 100 thinner than the first portion 95 is a way of obtaining higher energy levels in the second portion 100 than in the first portion 95 that is easily reproducible when the second portion 100 is thin enough to form a quantum well.

The first-thickness-to-second-thickness ratio comprised between 1.5 and 6 corresponds to an energy difference between the first and second portions 95, 100 that allows for a good repulsion of the carriers from the second portion 100.

The deposition of the light-emitting layers 85 on a mesa 40 whose angle α is comprised between 10 ° and 50 °allows one to easily obtain such a thinner second portion 100. Indeed, material deposited on such lateral faces 75 grows slower than when deposited onto the superior side 70 because of the geometry of usual material deposition chambers.

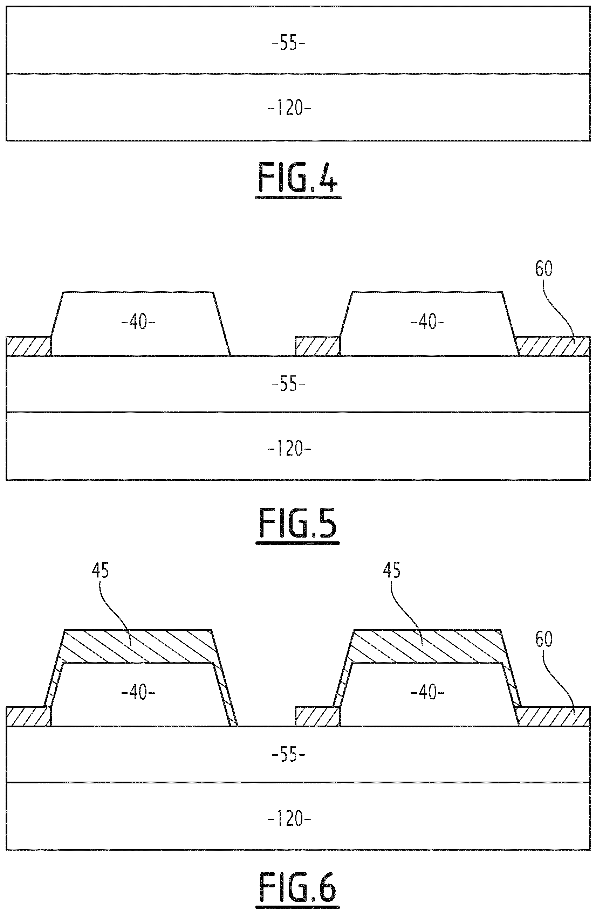

Such easy obtaining of the pixel 15 is now described in reference to an example of carrying out a method for fabricating such pixel 15 which is schematically illustrated by figures 4 to 12.

A method for fabricating the pixel 15 comprises a step for supplying, a step for creating, a step for insulating, a step for depositing, a step for forming, a step for connecting and a step for placing.

During the step for supplying, the substrate 55 is supplied. During the step for supplying, the substrate 55 comprises a support plate 120 supporting the substrate 55. The support plate 120 is, for example, a silicon or sapphire plate (see notably figure 4).

During the step for creating, each mesa 40 is created. For example, each mesa 40 is created by etching away part of a bulk made of the first material.

According to an embodiment, each mesa 40 is created by etching away part of the substrate 55 (see notably figure 5), in which case the bulk is the substrate 55.

According to a possible variant, the method comprises a step for depositing a layer of the first material onto the substrate 55. The layer is thus supported by the substrate 55. Each mesa 40 is then created by etching away part of said layer. In this case, the bulk is thus the layer of the first material that is supported by the substrate 55.

During the step for insulating, the insulating layer 60 is deposited on selected areas of the main surface of the substrate 55.

For example, the electrically insulating material is deposited onto the substrate 55 and the mesas 40, and then removed from the mesas 40. In other embodiments, a layer of photosensitive resin is deposited onto the mesas 40 so that the electrically insulating material is only deposited onto the main surface 65.

The step for depositing comprises the deposition of each covering layer 45 on the corresponding mesa 40 (see notably figure 6). For example, an identical covering layer 45 is deposited on each mesa 40.

The deposition is, for example, performed using a deposition technique such as Metal-Organic Chemical Vapor Deposition (MOCVD).

MOCVD is also called "MOVPE", which stands for "Metal-Organic Vapor Phase Epitaxy". Other Chemical Vapor Deposition (CVD) methods may also be envisioned.

However, other deposition techniques may be used, such as Molecular Beam Epitaxy (MBE), Gas-source MBE (GSMBE), Metal-Organic MBE (MOMBE), Plasma-assisted MBE (PAMBE), Atomic-layer Epitaxy (ALE), or Hydride Vapor Phase Epitaxy (HVPE).

Due to the different crystal orientations of the superior side 70 and the lateral side 75, the deposition of the light-emitting layers 85 results in the second thickness e2 being inferior to the first thickness e1. The ratio between the first thickness e1 and the second thickness e2 depends notably on the angle α.

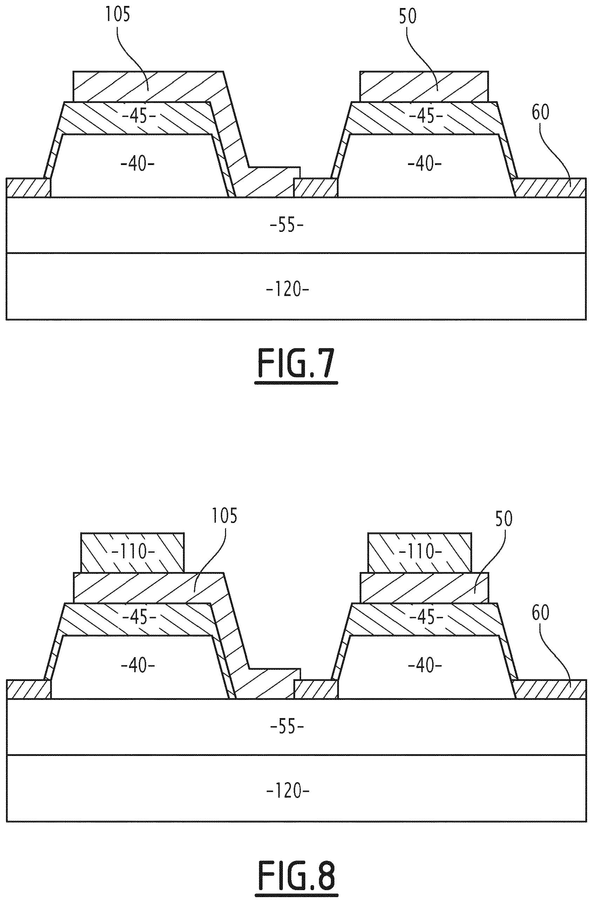

During the step for forming, each first electrical contact 50 is formed. For example, each first electrical contact 50 and each second electrical contact 105 are simultaneously deposited onto the corresponding mesas 40 and covering layers 45 as illustrated on figure 7.

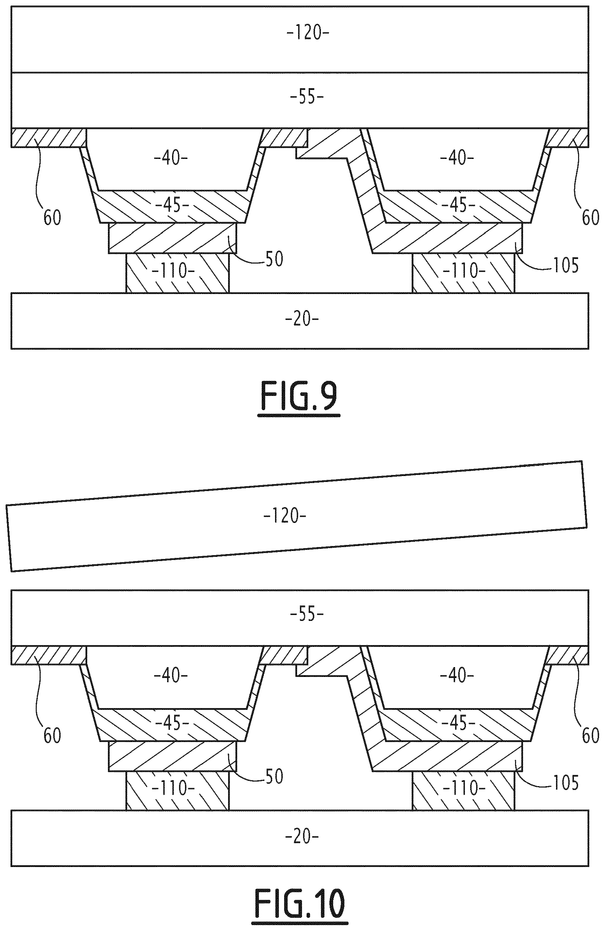

In an embodiment, a layer of protective resin is formed, prior to deposition, onto the substrate 55, the mesas 40 and the covering layers 45 and patterned to leave only apparent the areas onto which the electrical contacts 50, 105 are to be deposited (see figures 8 and 9).

The electrical contacts 50, 105 are, for example, deposited using a metal deposition technique such as electron beam deposition, thermal evaporation and sputter deposition.

Each first and second electrical contact 50, 105 is then electrically connected to the control circuit 20 during the step for connecting (see figure 9).

The support plate is removed from the substrate 55 to expose the bottom face 102 of the substrate 55 (see figure 10).

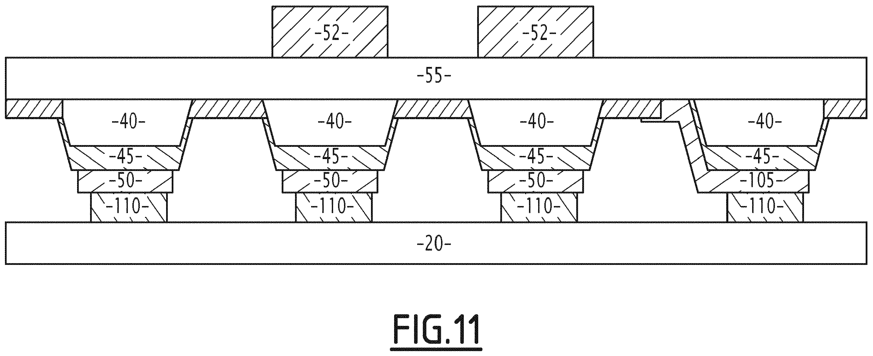

Each radiation converter 52 is then formed opposite the corresponding mesa 40 onto the bottom face 102. Lithography is an example of suitable method for placing such a converter (see figure 11).

The manufacturing of a pixel has been previously described in the case of a pixel 15 comprising several light emitters. A method for fabricating a single light emitter 25 may however comprise the step for supplying and the step for depositing, provided that only one mesa 40 is created during the creation step and that the covering layer 45 is deposited only on the created mesa 40 during the step for depositing.

Each method for fabricating is thus easy to implement.

Furthermore, since the mesas 40 are created by etching away part of an existing bulk of the first material, the shape of the mesas 40 may be efficiently controlled. In particular, the angle α can be chosen at will and is not limited by the angles obtained naturally during growth. Therefore, angles α allowing for a ratio of first and second thicknesses e1 and e2 compatible with good repulsion of the carriers from the second portions 100 can be obtained. In particular, the angle α may be modified depending on the desired thicknesses e1 and e2.

The emitter 25 also provides additional advantages which are now described.

When the first electrical contact 50 is electrically connected to the second portion 100, the electrical current travels between the second portion 100 and the first electrical contact 50 along the axis A. When the axis A is parallel to a semipolar direction of the crystalline structure, the injection of holes into the covering layer 45 is made easier.

Because of the larger contact area between the covering layer 45 and the first electrical contact 50, the voltage is reduced and the wall plug efficiency is improved (see figure 14).

The presence of the insulating layer 60 decreases the electrical losses through short-circuit between the substrate 55 and the covering layer 45. The same effect is obtained if the mesas 40 of neighboring light emitters are in contact with each other, since in that case also the electrical contact between the covering layers 45 and the substrate 55 is eliminated.

When the crystalline structure of the material is hexagonal, a hexagonal shape of the base 80 allows for the properties of the faces of the lateral side 75 to be identical to one another due to the hexagonal symmetry of wurtzite.

Furthermore, hexagonal or rectangular bases 80 allow for the mesas 40 to be arranged on the substrate 55 in a compact manner, and therefore for the pixel 15 to be smaller. The resolution of a display screen 10 including a set of pixels 15 is therefore higher.

Using light converters 52 allows light emitters 25 having identical light-emitting layers 85 to emit different first radiations, in particular different colors of first radiations, while being easily fabricated, since only one deposition step is performed to deposit all the light-emitting layers 85.

When each one of the three light emitters 25 of a single pixel 15 emits a different first radiation, the pixel may be used as a color pixel in a display screen.

However, embodiments in which one or several of the light emitters 25 do not comprise a radiation converter 52 may be envisioned. In this case, the radiation emitted by the light-emitting layers 85 is the first emission.

For example, two of the light emitters 25 comprise radiation converters 52 but the third light emitter 25 does not comprise any radiation converter 52, in particular when the third light emitter 25 emits a blue first radiation. In another embodiment, none of the light emitters 25 comprise radiation converters 52, the light-emitting layers 85 of the light emitters 25 being configured to emit first radiations having different mean wavelengths, for example if the second materials of the light emitters 25 are different.

Light emitters 25 deprived of radiation converter 52 are more efficient.

Furthermore, embodiments wherein each light emitter 25 comprises a radiation converter 52 may be envisioned. For example, each radiation-emitting layer 85 is an ultraviolet radiation, and each radiation converter 52 converts the ultraviolet radiation into the corresponding first radiation.

The mesa 40 has been described here above in the case of a truncated pyramidal shape. However, the shape of the mesa 40 may vary.

In an embodiment, the mesa 40 is in the shape of a truncated cone. For example, the superior side 70 and the base 80 are circular.

In the above example, only the second portion 100 has been described as a quantum well. However, embodiments in which the first portion 95 forms a quantum well may be envisioned. The emission efficiency of quantum wells is often superior to that of thicker layers.

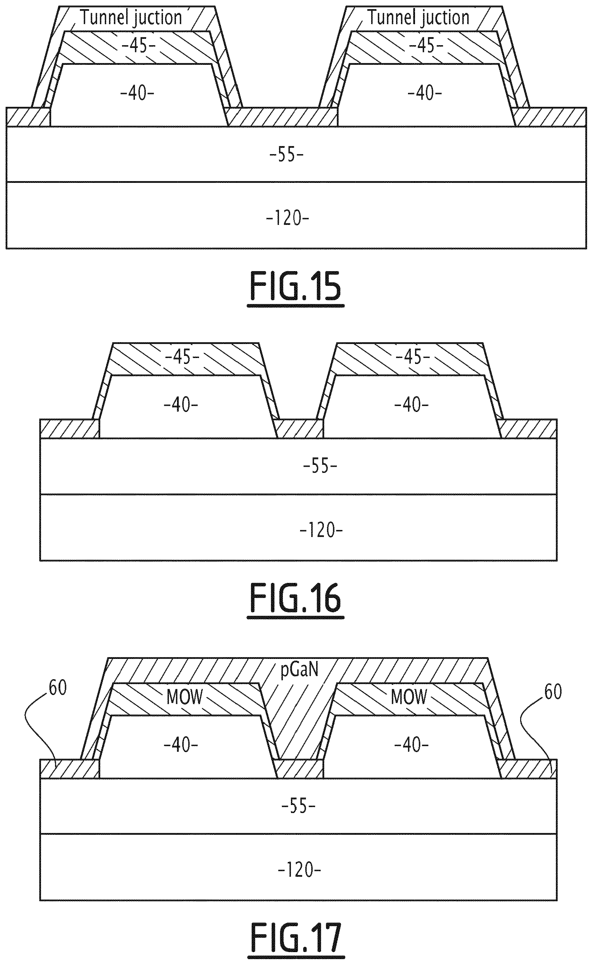

It is to be noted that a planarizing layer may be used. A planarizing layer is a layer of material deposited on the substrate 55, on the mesas 40 and on the covering layers 45 so that the mesas 40 and covering layers 45 are embedded in the planarizing layer which thus forms a planar surface. A planar surface may be beneficial for device processing and may provide a more uniform electrical injection (see figure 17).

The planarizing layer is, for example, made of the first semiconducting material.

In an embodiment, the planarizing layer is doped. In particular, the planarizing layer has a type of doping different from the mesa 40.

In a specific example, the planarizing layer is made of p-doped GaN.

The light-emitting layer 85 has been described as a compact layer of a single material. Embodiments in which the light-emitting layer 85 is a superlattice are also envisioned. Superlattices are layers formed by a stack of sublayers of two or more different materials, forming a pattern that is repeated along the stacking direction, the sublayers being so thin that a quantum coupling between sublayers exist.

The different semiconducting materials described hereabove are wurtzite-structure III-nitride materials. However, other crystalline structures and materials may be used.

For example, any one of the first, second, third and fourth semiconducting material may be chosen among arsenide materials such as AlAs, GaAs, InAs, among phosphide materials such as AIP, GaP, InP, among II-VI materials such as ZnSe, CdSe, ZnTe, CdTe, among IV-materials such as Si and Ge, or among any alloy of such materials.

As a general illustration of the different embodiments that may be considered, reference is notably made to the figures 13 to 17 which are schematic side views of examples of pixels.

Figure 13 corresponds to a mesa microLED; figure 14 to an overlapping p-metal; figure 15 to a tunnel junction contact ; figure 16 to a close packed mesa microLED and figure 17 to a close packed mesa microLED with planarized surface.

Furthermore, embodiments wherein superlattices are added beneath the quantum wells can be considered.

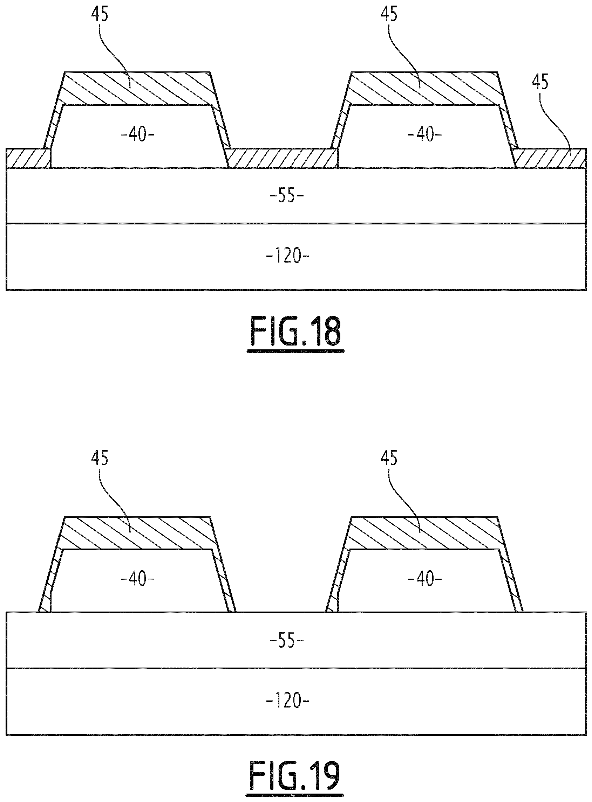

Another example of method for manufacturing the pixel 15 is depicted on figures 18 to 20.

According to this example, the covering layer 45 is deposited before deposition of the insulating layer 60. The covering layer 45 thus covers both the mesas 40 and the main surface 65 (see figure 18).

During a subsequent removal step, the part of the covering layer 45 that covers the main surface 65 is removed, for example by etching (see figure 19). In an embodiment, the portion of the covering layer 45 that covers the bottommost part of the mesas 40, and which is thus in electrical contact with the main surface 65, is also removed.

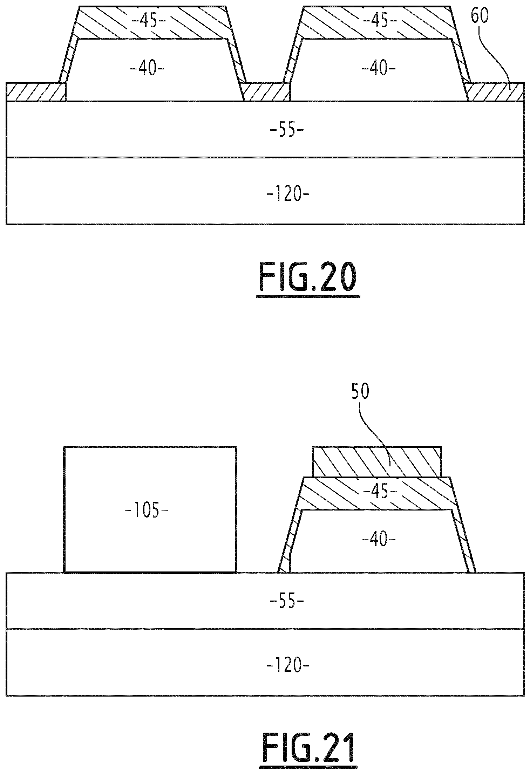

The insulating step may optionally be performed after removal to cover the main surface 65 with electrically insulating material (see figure 20).

The connecting structure 30 has been described above as comprising a mesa 40, a covering layer 45 and a second electrical contact 105. However, simpler embodiments wherein the connecting structure only comprises the second electrical contact 105 may be envisioned. In this case, the second electrical contact is, for example, a block of electrically conductive material whose total height is equal to the total height of the emitters 25 (see figure 21).

The scope of the present invention is defined by the following claims.

## Claims

1. An emitter (25) adapted to emit a first radiation, the emitter (25) comprising:
- a substrate (55),
- a mesa (40), the mesa (40) being made of a first semiconductor material, the first semiconductor material having a first bandgap value, the mesa (40) having a superior side (70) and a lateral side (75), the lateral side (75) surrounding the superior side (70) and extending between the substrate (55) and the superior side (70),
- a covering layer (45) comprising at least one radiation-emitting layer (85), the at least one radiation-emitting layer (85) being made of a second semiconductor material, the second semiconductor material having a second bandgap value, the second bandgap value being strictly inferior to the first bandgap value, each radiation-emitting layer (85) having a first portion (95) corresponding to the superior side (70) and a second portion (100) corresponding to the lateral side (75), a first thickness (e1) being defined for the first portion (95) and a second thickness (e2) being defined for the second portion (100), the second thickness (e2) being strictly inferior to the first thickness (e1),
the ratio between the first thickness (e1) and the second thickness (e2) being comprised between 1.5 and 6, and the superior side (70) having a surface comprised between 9 square micrometers and 900 square micrometers.

2. The emitter according to claim 1, wherein at least one of the following properties is fulfilled:
- the first portion (95) covers at least partially the superior side (70) of the mesa and the second portion (100) covers at least partially the lateral side (75) of the mesa (40);
- the second portion (100) forms at least one quantum well, and
- the lateral side (75) comprises a plurality of plane faces.

3. The emitter according to claim 1 or 2, wherein at least one of the following properties is fulfilled:
- the substrate (55) is made of a semiconducting material, the mesa (40) extending along a first direction (D) perpendicular to the substrate (55) from the substrate (55) and being electrically connected to the substrate (55), the substrate (55) having a main surface (65) surrounding the mesa (40) in a plane perpendicular to the first direction (D), the substrate (55) further comprising an electrically insulating layer (60) extending on the main surface (65), the insulating layer (60) forming a barrier between the substrate (55) and the covering layer (45), and
- for each point of the lateral side (75), an axis (A) corresponding to the direction passing through the point and perpendicular to the lateral side (75) is defined, and wherein the angle (α) between a first direction (D) perpendicular to the substrate (55) and the axis (A) is comprised between 30 degrees and 80 degrees.

4. The emitter according to any one of claims 1 to 3, wherein at least one of the following properties is fulfilled:
- at least one of the first semiconductor material and the second semiconductor material is a III-nitride material, and
- a crystalline structure is defined for the first semiconductor material, the crystalline structure having at least one polar direction and at least one semipolar direction, the superior side (70) being perpendicular to the polar axis, an axis (A) corresponding to the direction passing through the lateral side (75) and perpendicular to the lateral side (75) being defined for each point of the lateral side (75), the axis (A) being perpendicular to the semipolar direction.

5. The emitter according to any one of claims 1 to 4, wherein at least one of the following properties is fulfilled:
- the emitter (25) further comprises a first electrical contact (50) electrically connected to the first portion (95), the emitter (25) being configured to emit the first radiation when an electrical current flows through the first electrical contact (50), the covering layer (45) and the mesa (40), the first electrical contact (50) further being electrically connected to the second portion (100);
- the emitter (25) further comprises a first electrical contact (50) electrically connected to the first portion (95), the emitter (25) being configured to emit the first radiation when an electrical current flows through the first electrical contact (50), the covering layer (45) and the mesa (40), the first electrical contact (50) comprising a first connection layer and a second barrier layer, the second barrier layer being interposed between the first connection layer and the covering layer (45), the first connection layer being made of a fourth material, the fourth material being a electrically conductive material or a semiconducting material, the second barrier layer being made of an insulating material, the covering layer (45), the second barrier layer and the first connection layer forming a tunnel junction;
- the covering layer (45) comprises at least two superimposed radiation-emitting layers (85) made of the second semiconductor material, a first barrier layer (90) made of a third semiconductor material being interposed between each pair of successive radiation-emitting layers (85), the third semiconductor material having a third bandgap value, the third bandgap value being strictly superior to the second bandgap value, and
- the first radiation comprises a first set of electromagnetic waves, the radiation-emitting layer (85) being configured to emit a second radiation comprising a second set of electromagnetic waves, the emitter (25) further comprising a radiation converter (52) configured to absorb the second radiation and to emit in response the first radiation, a wavelength being defined for each electromagnetic wave, the first set corresponding to a first range of wavelengths and the second set corresponding to a second range of wavelengths, the first range having a first mean wavelength and the second range having a second mean wavelength, the first mean wavelength being different from the second mean wavelength.

6. The emitter according to any one of claims 1 to 5, wherein at least one of the following properties is fulfilled:
- the mesa (40) has a minimum lateral dimension (I) and a height (h), the height (h) being measured in a first direction (D) perpendicular to the substrate (55) and the minimum lateral dimension (I) being measured in a plane perpendicular to the first direction (D) , the height (h) being strictly inferior to the minimum lateral dimension (I);
- the mesa (40) forms a frustum having a base (80) in contact with the substrate (55), the base (80) being a rectangle or a hexagon;
- the mesa (40) has a height (h) measured along a first direction (D) perpendicular to the substrate (55), the height (h) being comprised between 100 nanometers and 1000 nanometers.

7. The emitter of any one of claims 1 to 6, wherein, for each point of the lateral side (75), an axis (A) corresponding to the direction passing through the point and perpendicular to the lateral side (75) is defined, and wherein the angle (α) between a first direction (D) perpendicular to the substrate (55) and the axis (A) is comprised between 55 degrees and 65 degrees.

8. An emitting device (15) comprising at least two emitters (25) according to any one of claims 1 to 7.

9. A display screen (10) comprising a set of emitting devices (15) according to claim 8.

10. A method for fabricating an emitter (25) adapted to emit a first radiation, the method comprising steps for:
- supplying a substrate (55),
- creating a mesa (40) made of a first semiconductor material, the first semiconductor material having a first bandgap value, the mesa (40) having a superior side (70) and a lateral side (75), the lateral side (75) surrounding the superior side (70) and extending between the substrate (55) and the superior side (70), and
- depositing on the mesa (40) a covering layer (45) comprising at least one radiation-emitting layer (85), the at least one radiation-emitting layer (85) being made of a second semiconductor material, the second semiconductor material having a second bandgap value, the second bandgap value being strictly inferior to the first bandgap value, each radiation-emitting layer (85) having a first portion (95) corresponding to the superior side (70) and a second portion (100) corresponding to the lateral side (75), a first thickness (e1) being defined for the first portion (95) and a second thickness (e2) being defined for the second portion (100), the second thickness (e2) being strictly inferior to the first thickness (e1),
the ratio between the first thickness (e1) and the second thickness (e2) being comprised between 1.5 and 6, and the superior side (70) having a surface comprised between 9 square micrometers and 900 square micrometers.

11. The method according to claim 10, wherein the step for creating a mesa (40) comprises etching away part of a bulk made of the first material to create the mesa (40).

12. A method for fabricating an emitting device (15) comprising a first emitter (25) and at least one second emitter (25), each emitter (25) being adapted to emit a corresponding first radiation, the method comprising steps for:
- supplying a substrate (55),
- creating, for each emitter (25), a mesa (40) made of a first semiconductor material, the first semiconductor material having a first bandgap value, the mesa (40) having a superior side (70) and a lateral side (75), the lateral side (75) surrounding the superior side (70) and extending between the substrate (40) and the superior side (75), and
- depositing on each mesa (40) a covering layer (45) comprising at least one radiation-emitting layer (85), the at least one radiation-emitting layer (85) being made of a second semiconductor material, the second semiconductor material having a second bandgap value, the second bandgap value being strictly inferior to the first bandgap value, each radiation-emitting layer (85) having a first portion (95) corresponding to the superior side (70) and a second portion (100) corresponding to the lateral side (75), a first thickness (e1) being defined for the first portion (95) and a second thickness (e2) being defined for the second portion (100), the second thickness (e2) being strictly inferior to the first thickness (e1),
the ratio between the first thickness (e1) and the second thickness (e2) being comprised between 1.5 and 6, and the superior side (70) having a surface comprised between 9 square micrometers and 900 square micrometers.

13. The method according to claim 12, wherein the step for creating each mesa (40) comprises etching away part of a bulk made of the first material to create each mesa (40).

14. The method according to claim 11 or 13, wherein the bulk is the substrate (55), the substrate being made of the first material.

15. The method according to claim 11 or 13, wherein the bulk is a layer made of the first material and supported by the substrate (55).

## Patentansprüche

1. Emitter (25), der angepasst ist, um eine erste Strahlung zu emittieren, der Emitter (25) umfassend:
- ein Substrat (55),
- eine Mesa (40), wobei die Mesa (40) aus einem ersten Halbleitermaterial gefertigt ist, wobei das erste Halbleitermaterial einen ersten Bandlückenwert aufweist, die Mesa (40) eine obere Seite (70) und eine laterale Seite (75) aufweist, wobei die laterale Seite (75) die obere Seite (70) umgibt und sich zwischen dem Substrat (55) und der oberen Seite (70) erstreckt,
- eine Deckschicht (45), umfassend mindestens eine strahlungsemittierende Schicht (85) umfasst, wobei die mindestens eine strahlungsemittierende Schicht (85) aus einem zweiten Halbleitermaterial gefertigt ist, wobei das zweite Halbleitermaterial einen zweiten Bandlückenwert aufweist, wobei der zweite Bandlückenwert strikt kleiner ist als der erste Bandlückenwert, wobei jede strahlungsemittierende Schicht (85) einen ersten Abschnitt (95), der der oberen Seite (70) entspricht, und einen zweiten Abschnitt (100), der der seitlichen Seite (75) entspricht, aufweist, wobei eine erste Stärke (e1) für den ersten Abschnitt (95) definiert ist und eine zweite Stärke (e2) für den zweiten Abschnitt (100) definiert ist, wobei die zweite Stärke (e2) strikt kleiner als die erste Stärke (e1) ist,
wobei das Verhältnis zwischen der ersten Stärke (e1) und der zweiten Stärke (e2) zwischen 1,5 und 6 ist und die obere Seite (70) eine Oberfläche zwischen 9 Quadratmikrometern und 900 Quadratmikrometern aufweist.

2. Emitter nach Anspruch 1, wobei mindestens eine der folgenden Eigenschaften erfüllt ist:
- der erste Abschnitt (95) bedeckt zumindest teilweise die obere Seite (70) der Mesa und der zweite Abschnitt (100) bedeckt zumindest teilweise die laterale Seite (75) der Mesa (40);
- der zweite Abschnitt (100) bildet mindestens einen Quantentopf, und
- die laterale Seite (75) umfasst eine Vielzahl von ebenen Flächen.

3. Emitter nach Anspruch 1 oder 2, wobei mindestens eine der folgenden Eigenschaften erfüllt ist:
- das Substrat (55) ist aus einem halbleitenden Material gefertigt, wobei sich die Mesa (40) entlang einer ersten Richtung (D) senkrecht zu dem Substrat (55) von dem S
- ubstrat (55) erstreckt und elektrisch mit dem Substrat (55) verbunden ist, wobei das Substrat (55) eine Hauptoberfläche (65) aufweist, die die Mesa (40) in einer Ebene senkrecht zu der ersten Richtung (D) umgibt, das Substrat (55) ferner umfassend eine elektrisch isolierende Schicht,
(60) die sich auf der Hauptoberfläche (65) erstreckt, wobei die Isolierschicht (60) eine Barriere zwischen dem Substrat (55) und der Deckschicht (45) bildet, und
- für jeden Punkt der lateralen Seite (75) ist eine Achse (A) definiert, die der Richtung entspricht, die durch den Punkt und senkrecht zu der lateralen Seite (75) verläuft, und wobei der Winkel (α) zwischen einer ersten Richtung (D) senkrecht zu dem Substrat (55) und der Achse (A) zwischen 30 Grad und 80 Grad liegt.

4. Verwendung nach einem der Ansprüche 1 bis 3, wobei mindestens eine der folgenden Eigenschaften erfüllt ist:
- mindestens eines von dem ersten Halbleitermaterial und dem zweiten Halbleitermaterial ist ein III-Nitrid-Material, und
- eine kristalline Struktur ist für das erste Halbleitermaterial definiert, wobei die kristalline Struktur mindestens eine polare Richtung und mindestens eine semipolare Richtung aufweist, wobei die obere Seite (70) senkrecht zu der polaren Achse ist und eine Achse (A), die der Richtung entspricht, durch die laterale Seite (75) verläuft und senkrecht zu der lateralen Seite (75)
für jeden Punkt der lateralen Seite (75) definiert ist, wobei die Achse (A) senkrecht zu der semipolaren Richtung ist.

5. Verwendung nach einem der Ansprüche 1 bis 4, wobei mindestens eine der folgenden Eigenschaften erfüllt ist:
- der Emitter (25) umfasst ferner einen ersten elektrischen Kontakt (50), der elektrisch mit dem ersten Abschnitt (95) verbunden ist, wobei der Emitter (25) konfiguriert ist, um die erste Strahlung zu emittieren, wenn ein elektrischer Strom durch den ersten elektrischen Kontakt (50), die Deckschicht (45) und die Mesa (40) fließt, wobei der erste elektrische Kontakt (50) ferner elektrisch mit dem zweiten Abschnitt (100) verbunden ist;
- der Emitter (25) umfasst ferner einen ersten elektrischen Kontakt (50), der elektrisch mit dem ersten Abschnitt (95) verbunden ist, wobei der Emitter (25) konfiguriert ist, um die erste Strahlung zu emittieren, wenn ein elektrischer Strom durch den ersten elektrischen Kontakt (50), die Deckschicht (45) und die Mesa (40) fließt, wobei der erste elektrische Kontakt (50) eine erste Verbindungsschicht und eine zweite Barriereschicht umfasst, die zweite Barriereschicht zwischen der ersten Verbindungsschicht und der Deckschicht (45) angeordnet ist, wobei die erste Verbindungsschicht aus einem vierten Material gefertigt ist, wobei das vierte Material ein elektrisch leitendes Material oder ein halbleitendes Material ist, die zweite Barriereschicht aus einem isolierenden Material hergestellt ist, die Deckschicht (45), die zweite Barriereschicht und die erste Verbindungsschicht einen Tunnelübergang bilden;
- die Deckschicht (45) umfasst mindestens zwei übereinanderliegende strahlungsemittierende Schichten (85), die aus dem zweiten Halbleitermaterial gefertigt sind, wobei eine erste Barriereschicht (90), die aus einem dritten Halbleitermaterial gefertigt ist, zwischen jedes Paar aufeinanderfolgender strahlungsemittierender Schichten (85) eingefügt ist, wobei das dritte Halbleitermaterial einen dritten Bandlückenwert aufweist, wobei der dritte Bandlückenwert strikt größer ist als der zweite Bandlückenwert, und
- die erste Strahlung umfasst einen ersten Satz elektromagnetischer Wellen, wobei die strahlungsemittierende Schicht (85) konfiguriert ist, um eine zweite Strahlung umfassend einen zweiten Satz elektromagnetischer Wellen zu emittieren, der Emitter (25) ferner umfassend einen Strahlungskonverter (52), der konfiguriert ist, um die zweite Strahlung zu absorbieren und um als Reaktion darauf die erste Strahlung zu emittieren, wobei für jede elektromagnetische Welle eine Wellenlänge definiert ist, wobei der erste Satz einem ersten Bereich von Wellenlängen und der zweite Satz einem zweiten Bereich von Wellenlängen entspricht, wobei der erste Bereich eine erste mittlere Wellenlänge und der zweite Bereich eine zweite mittlere Wellenlänge aufweist, wobei die erste mittlere Wellenlänge von der zweiten mittleren Wellenlänge verschieden ist.

6. Verwendung nach einem der Ansprüche 1 bis 5, wobei mindestens eine der folgenden Eigenschaften erfüllt ist:
- die Mesa (40) weist eine minimale seitliche Abmessung (I) und eine Höhe (h) auf, wobei die Höhe (h) in einer ersten Richtung (D) senkrecht zu dem Substrat (55) gemessen wird und die minimale seitliche Abmessung (I) in einer Ebene senkrecht zu der ersten Richtung (D) gemessen wird, wobei die Höhe (h) strikt kleiner ist als die minimale seitliche Abmessung (I);
- die Mesa (40) einen Kegelstumpf bildet, der eine Basis (80) in Kontakt mit dem Substrat (55) aufweist, wobei die Basis (80) ein Rechteck oder ein Sechseck ist;
- die Mesa (40) eine Höhe (h) aufweist, die entlang einer ersten Richtung (D) senkrecht zu dem Substrat (55) gemessen wird, wobei die Höhe (h) zwischen 100 Nanometer und 1000 Nanometer liegt.

7. Emitter nach einem der Ansprüche 1 bis 6, wobei für jeden Punkt der lateralen Seite (75) eine Achse (A) definiert ist, die der Richtung entspricht, die durch den Punkt und senkrecht zu der lateralen Seite (75) verläuft, und wobei der Winkel (α) zwischen einer ersten Richtung (D) senkrecht zu dem Substrat (55) und der Achse (A) zwischen 55 Grad und 65 Grad liegt.

8. Emittierende Vorrichtung (15), umfassend mindestens zwei Emitter (25) nach einem der Ansprüche 1 bis 7.

9. Anzeigebildschirm (10), umfassend einen Satz von emittierenden Vorrichtungen (15) nach Anspruch 8.

10. Verfahren zum Herstellen eines Emitters (25), der angepasst ist, um eine erste Strahlung zu emittieren, das Verfahren umfassend die folgenden Schritte:
- Liefern eines Substrats (55),
- Erzeugen einer Mesa (40) aus einem ersten Halbleitermaterial, wobei das erste Halbleitermaterial einen ersten Bandlückenwert aufweist, die Mesa (40) eine obere Seite (70) und eine laterale Seite (75) aufweist, wobei die laterale Seite (75) die obere Seite (70) umgibt und sich zwischen dem Substrat (55) und der oberen Seite (70) erstreckt, und
- Abscheiden einer Deckschicht (45) auf der Mesa (40), umfassend mindestens eine strahlungsemittierende Schicht (85) umfasst, wobei die mindestens eine strahlungsemittierende Schicht (85) aus einem zweiten Halbleitermaterial gefertigt ist, wobei das zweite Halbleitermaterial einen zweiten Bandlückenwert aufweist, wobei der zweite Bandlückenwert strikt kleiner ist als der erste Bandlückenwert, wobei jede strahlungsemittierende Schicht (85) einen ersten Abschnitt (95), der der oberen Seite (70) entspricht, und einen zweiten Abschnitt (100), der der seitlichen Seite (75) entspricht, aufweist, wobei eine erste Stärke (e1) für den ersten Abschnitt (95) definiert ist und eine zweite Stärke (e2) für den zweiten Abschnitt (100) definiert ist, wobei die zweite Stärke (e2) strikt kleiner als die erste Stärke (e1) ist,
wobei das Verhältnis zwischen der ersten Stärke (e1) und der zweiten Stärke (e2) zwischen 1,5 und 6 ist und die obere Seite (70) eine Oberfläche zwischen 9 Quadratmikrometern und 900 Quadratmikrometern aufweist.

11. Verfahren nach Anspruch 10, wobei der Schritt zum Schaffen einer Mesa (40) ein Wegätzen eines Teils einer aus dem ersten Material bestehenden Masse umfasst, um die Mesa (40) zu schaffen.

12. Verfahren zum Herstellen einer emittierenden Vorrichtung (15), umfassend einen ersten Emitter (25) und mindestens einen zweiten Emitter (25), wobei jeder Emitter (25) angepasst ist, um eine entsprechende erste Strahlung zu emittieren, das Verfahren umfassend die folgenden Schritte:
- Liefern eines Substrats (55),
- Schaffen, für jeden Emitter (25) einer Mesa (40) aus einem ersten Halbleitermaterial, wobei das erste Halbleitermaterial einen ersten Bandlückenwert aufweist, die Mesa (40) eine obere Seite (70) und eine laterale Seite (75) aufweist, wobei die laterale Seite (75) die obere Seite (70) umgibt und sich zwischen dem Substrat (40) und der oberen Seite (75) erstreckt, und
- Abscheiden, auf jeder Mesa (40) einer Deckschicht (45), umfassend mindestens eine strahlungsemittierende Schicht
(85) umfasst, wobei die mindestens eine strahlungsemittierende Schicht (85) aus einem zweiten Halbleitermaterial gefertigt ist, wobei das zweite Halbleitermaterial einen zweiten Bandlückenwert aufweist, wobei der zweite Bandlückenwert strikt kleiner ist als der erste Bandlückenwert, wobei jede strahlungsemittierende Schicht (85) einen ersten Abschnitt (95), der der oberen Seite (70) entspricht, und einen zweiten Abschnitt (100), der der seitlichen Seite (75) entspricht, aufweist, wobei eine erste Stärke (e1) für den ersten Abschnitt (95) definiert ist und eine zweite Stärke (e2) für den zweiten Abschnitt (100) definiert ist, wobei die zweite Stärke (e2) strikt kleiner als die erste Stärke (e1) ist,
wobei das Verhältnis zwischen der ersten Stärke (e1) und der zweiten Stärke (e2) zwischen 1,5 und 6 ist und die obere Seite (70) eine Oberfläche zwischen 9 Quadratmikrometern und 900 Quadratmikrometern aufweist.

13. Verfahren nach Anspruch 12, wobei der Schritt zum Schaffen jeder Mesa (40) ein Wegätzen eines Teils einer aus dem ersten Material bestehenden Masse umfasst, um jede Mesa (40) zu schaffen.

14. Verfahren nach Anspruch 11 oder 13, bei dem die Masse das Substrat (55) ist, wobei das Substrat aus dem ersten Material gefertigt ist.

15. Verfahren nach Anspruch 11 oder 13, wobei die Masse eine Schicht ist, die aus dem ersten Material gefertigt ist, die von dem Substrat (55) getragen wird.

## Revendications

1. Émetteur (25) adapté pour émettre une première radiation, l'émetteur (25) comprenant :
- un substrat (55),
- une mesa (40), la mesa (40) étant constituée d'un premier matériau semi-conducteur, le premier matériau semi-conducteur présentant une première valeur de bande interdite, la mesa (40) présentant une face supérieure (70) et une face latérale (75), la face latérale (75) entourant la face supérieure (70) et s'étendant entre le substrat (55) et la face supérieure (70),
- une couche de recouvrement (45) comprenant au moins une couche émettrice de radiation (85), la au moins une couche émettrice de radiation (85) étant constituée d'un deuxième matériau semi-conducteur, le deuxième matériau semi-conducteur présentant une seconde valeur de bande interdite, la seconde valeur de bande interdite étant strictement inférieure à la première valeur de bande interdite, chaque couche émettrice de radiation (85) présentant une première partie (95) correspondant à la face supérieure (70) et une seconde partie (100) correspondant à la face latérale (75), une première épaisseur (e1) étant définie pour la première partie (95) et une seconde épaisseur (e2) étant définie pour la seconde partie (100), la seconde épaisseur (e2) étant strictement inférieure à la première épaisseur (e1),
le rapport entre la première épaisseur (e1) et la seconde épaisseur (e2) étant compris entre 1,5 et 6, et la face supérieure (70) présentant une surface comprise entre 9 micromètres carrés et 900 micromètres carrés.

2. Émetteur selon la revendication 1, dans lequel au moins une des propriétés suivantes est remplie :
- la première partie (95) couvre au moins partiellement le côté supérieur (70) de la mesa et la seconde partie (100) couvre au moins partiellement le côté latéral (75) de la mesa (40) ;
- la seconde partie (100) forme au moins un puits quantique, et
- la face latérale (75) comprend plusieurs faces planes.

3. Émetteur selon la revendication 1 ou 2, dans lequel au moins une des propriétés suivantes est remplie :
- le substrat (55) est constitué d'un matériau semi-conducteur, la mesa (40) s'étendant le long d'une première direction (D) perpendiculaire au substrat (55) à partir du substrat (55) et étant connectée électriquement au substrat (55), le substrat (55) présentant une surface principale (65) entourant la mesa (40) dans un plan perpendiculaire à la première direction (D), le substrat (55) comprenant en outre une couche électriquement isolante
(60) s'étendant sur la surface principale (65), la couche isolante (60) formant une barrière entre le substrat (55) et la couche de recouvrement (45), et
- pour chaque point du côté latéral (75), un axe (A) correspondant à la direction passant par le point et perpendiculaire au côté latéral (75) est défini, et dans lequel l'angle (α) entre une première direction (D) perpendiculaire au substrat (55) et l'axe (A) est compris entre 30 degrés et 80 degrés.

4. Émetteur selon l'une quelconque des revendications 1 à 3, dans lequel au moins une des propriétés suivantes est remplie :
- au moins l'un du premier matériau semi-conducteur et du deuxième matériau semi-conducteur est un matériau III-nitrure, et
- une structure cristalline est définie pour le premier matériau semi-conducteur, la structure cristalline présentant au moins une direction polaire et au moins une direction semi-polaire, le côté supérieur (70) étant perpendiculaire à l'axe polaire, un axe (A) correspondant à la direction passant par le côté latéral (75) et perpendiculairement à la face latérale (75)
étant défini pour chaque point de la face latérale (75), l'axe (A) étant perpendiculaire à la direction semi-polaire.

5. Émetteur selon l'une quelconque des revendications 1 à 4, dans lequel au moins une des propriétés suivantes est remplie :
- l'émetteur (25) comprend en outre un premier contact électrique (50) branché électriquement à la première partie (95), l'émetteur (25) étant configuré pour émettre la première radiation lorsqu'un courant électrique traverse le premier contact électrique (50), la couche de revêtement (45) et la mésa (40), le premier contact électrique (50) étant en outre branché électriquement à la seconde partie (100) ;
- l'émetteur (25) comprend en outre un premier contact électrique (50) branché électriquement à la première partie (95), l'émetteur (25) étant configuré pour émettre la première radiation lorsqu'un courant électrique traverse le premier contact électrique (50), la couche de recouvrement (45) et la mésa (40), le premier contact électrique (50) comprenant une première couche de connexion et une seconde couche barrière, la seconde couche barrière étant interposée entre la première couche de connexion et la couche de recouvrement (45), la première couche de connexion étant constituée d'un quatrième matériau, le quatrième matériau étant un matériau électriquement conducteur ou un matériau semi-conducteur, la seconde couche barrière étant constituée d'un matériau isolant, la couche de recouvrement (45), la seconde couche barrière et la première couche de connexion formant une jonction en tunnel ;
- la couche de recouvrement (45) comprend au moins deux couches émettrices de radiations superposées (85) constituées du deuxième matériau semi-conducteur, une première couche barrière (90) constituée d'un troisième matériau semi-conducteur étant interposée entre chaque paire de couches émettrices de radiation successives (85), le troisième matériau semi-conducteur présentant une troisième valeur de bande interdite, la troisième valeur de bande interdite étant strictement supérieure à la deuxième valeur de bande interdite, et
- le premier rayonnement comprend un premier ensemble d'ondes électromagnétiques, la couche émettrice de radiations (85) étant configurée pour émettre une seconde radiation comprenant un second ensemble d'ondes électromagnétiques, l'émetteur (25) comprenant en outre un convertisseur de radiation (52) configuré pour absorber la seconde radiation et pour émettre en réponse la première radiation, une longueur d'onde étant définie pour chaque onde électromagnétique, le premier ensemble correspondant à une première gamme de longueurs d'onde et le deuxième ensemble correspondant à une seconde gamme de longueurs d'onde, la première gamme présentant une première longueur d'onde moyenne et la seconde gamme présentant une deuxième longueur d'onde moyenne, la première longueur d'onde moyenne étant différente de la seconde longueur d'onde moyenne.

6. Émetteur selon l'une quelconque des revendications 1 à 5, dans lequel au moins une des propriétés suivantes est remplie :
- la mesa (40) présente une dimension latérale minimale (I) et une hauteur (h), la hauteur (h) étant mesurée dans une première direction (D) perpendiculaire au substrat (55) et la dimension latérale minimale (I) étant mesurée dans un plan perpendiculaire à la première direction (D), la hauteur (h) étant strictement inférieure à la dimension latérale minimale (I) ;
- la mesa (40) forme un tronc doté d'une base (80) en contact avec le substrat (55), la base (80) étant un rectangle ou un hexagone ;
- la mesa (40) présente une hauteur (h) mesurée le long d'une première direction (D) perpendiculaire au substrat (55), la hauteur (h) étant comprise entre 100 nanomètres et 1000 nanomètres.

7. Émetteur selon l'une quelconque des revendications 1 à 6, dans lequel, pour chaque point du côté latéral (75), un axe (A) correspondant à la direction passant par le point et perpendiculaire au côté latéral (75) est défini, et dans lequel l'angle (α) entre une première direction (D) perpendiculaire au substrat (55) et l'axe (A) est compris entre 55 degrés et 65 degrés.

8. Dispositif émetteur (15) comprenant au moins deux émetteurs (25) selon l'une quelconque des revendications 1 à 7.

9. Écran d'affichage (10) comprenant un ensemble de dispositifs d'émission (15) selon la revendication 8.

10. Procédé de fabrication d'un émetteur (25) conçu pour émettre une première radiation, le procédé comprenant des étapes pour :
- fournir un substrat (55),
- créer une mesa (40) constituée d'un premier matériau semi-conducteur, le premier matériau semi-conducteur présentant une première valeur de bande interdite, la mesa (40) présentant une face supérieure (70) et une face latérale (75), la face latérale (75) entourant la face supérieure (70) et s'étendant entre le substrat (55) et la face supérieure (70),
- déposer sur la mesa (40) une couche de recouvrement (45) comprenant au moins une couche émettrice de radiation (85), la au moins une couche émettrice de radiation (85) étant constituée d'un deuxième matériau semi-conducteur, le deuxième matériau semi-conducteur présentant une seconde valeur de bande interdite, la seconde valeur de bande interdite étant strictement inférieure à la première valeur de bande interdite, chaque couche émettrice de radiation (85) présentant une première partie (95) correspondant à la face supérieure (70) et une seconde partie (100) correspondant à la face latérale (75), une première épaisseur (e1) étant définie pour la première partie (95) et une seconde épaisseur (e2) étant définie pour la seconde partie (100), la seconde épaisseur (e2) étant strictement inférieure à la première épaisseur (e1),
le rapport entre la première épaisseur (e1) et la seconde épaisseur (e2) étant compris entre 1,5 et 6, et la face supérieure (70) présentant une surface comprise entre 9 micromètres carrés et 900 micromètres carrés.

11. Procédé selon la revendication 10, dans lequel l'étape de création d'une mesa (40) comprend la gravure par désagrégation d'une partie d'une masse constituée du premier matériau pour créer la mesa (40).

12. Procédé de fabrication d'un dispositif émetteur (15) comprenant un premier émetteur (25) et au moins un second émetteur (25), chaque émetteur (25) étant adapté pour émettre une première radiation correspondante, le procédé comprenant des étapes pour :
- fournir un substrat (55),
- créer, pour chaque émetteur (25), une mesa (40) constituée d'un premier matériau semi-conducteur, le premier matériau semi-conducteur présentant une première valeur de bande interdite, la mesa (40) présentant une face supérieure (70) et une face latérale (75), la face latérale (75) entourant la face supérieure (70) et s'étendant entre le substrat (40) et la face supérieure (75), et
- déposer sur chaque mesa (40) une couche de recouvrement (45) comprenant au moins une couche émettrice de radiation
(85), la au moins une couche émettrice de radiation (85) étant constituée d'un deuxième matériau semi-conducteur, le deuxième matériau semi-conducteur présentant une seconde valeur de bande interdite, la seconde valeur de bande interdite étant strictement inférieure à la première valeur de bande interdite, chaque couche émettrice de radiation (85) présentant une première partie (95) correspondant à la face supérieure (70) et une seconde partie (100) correspondant à la face latérale (75), une première épaisseur (e1) étant définie pour la première partie (95) et une seconde épaisseur (e2) étant définie pour la seconde partie (100), la seconde épaisseur (e2) étant strictement inférieure à la première épaisseur (e1),
le rapport entre la première épaisseur (e1) et la seconde épaisseur (e2) étant compris entre 1,5 et 6, et la face supérieure (70) présentant une surface comprise entre 9 micromètres carrés et 900 micromètres carrés.

13. Procédé selon la revendication 12, dans lequel l'étape de création de chaque mesa (40) comprend la gravure par désagrégation d'une partie d'une masse constituée du premier matériau pour créer chaque mesa (40).

14. Procédé selon la revendication 11 ou 13, dans lequel la masse est le substrat (55), le substrat étant constitué du premier matériau.

15. Procédé selon la revendication 11 ou 13, dans lequel la masse est une couche constituée du premier matériau et supportée par le substrat (55).
